# EUROPEAN PATENT SPECIFICATION

(11) **EP 1 508 584 B1**
(45) Date of publication and mention of the grant of the patent: **20.05.2009**
(21) Application number: 03733169.1
(22) Date of filing: 29.05.2003
(51) Int. Cl.: C09J 7/02, C08G 73/10

(54) **ADHESIVE RESIN AND FILM ADHESIVES MADE BY USING THE SAME**
KLEBHARZ UND DAMIT HERGESTELLTE FILMKLEBSTOFFE
RESINE ADHESIVE ET ADHESIFS SOUS FORME DE FILMS LA CONTENANT

(30) Priority: 30.05.2002 JP 2002156705; 11.06.2002 JP 2002170216
(43) Date of publication of application: 23.02.2005
(73) Proprietor: Mitsui Chemicals, Inc., Tokyo 105-7117 (JP)
(72) Inventor: KINOSHITA, Jin, Mitsui Chemicals, Inc., Nagoya-shi, Aichi 457-8522 (JP); MORITA, Moritsugu, c/o Mitsui Chemicals, Inc., Minato-ku Tokyo 105-7117 (JP); MORI, Minehiro, c/oMitsui Chemicals, Inc., Minato-ku, Tokyo 105-7117 (JP); KODAMA, Yoichi, Mitsui Chemicals, Inc., Sodegaura-shi, Chiba 299-0265 (JP)
(74) Representative: HOFFMANN EITLE
(86) International application number: PCT/JP2003/006776
(87) International publication number: WO 2003/102049

(56) References cited:
- EP-A- 0 693 517
- EP-A1- 0 598 911
- WO-A-00/39236
- JP-A- 8 127 656
- JP-A- 8 134 213
- JP-A- 8 259 924
- US-A1- 5 959 068

## Description

### Technical Field

The present invention relates to an adhesive resin comprising a polyimide resin having a specific structure and that is useful in the field of semiconductors, a film adhesive comprising the adhesive resin suitable for attaching a semiconductor element to a support, and a semiconductor device made by using the film adhesive.

### Background Art

In recent years, a film adhesive referred to as die attach film has been used for attaching a semiconductor element to a support. Since such a film adhesive is excellent in controllability for thickness or protrusion in comparison with the conventional paste adhesives, the film adhesive is often used in a semiconductor package having small mounting areas (high-density mounting), such as chip-sized packages, stack package and system in package.

In such high-density mounting, chip thinning has proceeded. If the thickness of wafer is less than 100 µm, the surface protecting tape which has previously been adhered to the wafer at the step of wafer slicing, is retained as is when a die attach film is subjected to adhering to the wafer in order to prevent damage to the wafer. However, the surface protecting layer (a buffer-coated film such as polyimide, and the like) or the surface protecting tape for the wafer may be altered by heating in the adhering process of the die attach film to generate warping of the wafer, and thus may cause inconvenience in reception of wafer to cartridge, in convey and the like. Therefore, a die attach film which can be attached at low temperature (hereinafter, referred to as low-temperature adhesion.) is required.

Also in the die mount process, the substrate tends to be thinned in accordance with the thinning of semiconductor devices. If the heating temperature is high in the heating-compression process at a die mounter, warping of the large substrate for bulk sealing may occur, as described above for the sliced wafer. Therefore, a die attach film having excellent low-temperature adhesion is also required in this process.

In thin, high-density and surface mounting type package, peeling may easily occur at the die attach material part with a moisture absorption reflow test due to the facts that moisture absorption of the substrate material is high, that moisture penetration of IC package continues to increase with thinning and miniaturization, that conversion to environmentally-friendly lead-free solder having high melting point is promoted, and the like. Accordingly, an adhesive is required which has high resistance to moisture absorption in reflow as well as low-temperature adhesion, as described above.

Japanese Unexamined Patent Application Publication No. 5-25453 discloses a thermal-resistant resin adhesive comprising a polyimide siloxane obtained from biphenyl tetracarboxylic acid as the main aromatic tetracarboxylic acid component, and a diamino polysiloxane having a specific structure and an aromatic diamine as a diamine component, an epoxy compound, and an epoxy-curing agent as resin components, to obtain an adhesive which enables lamination of a metal foil and a heat-resistant support material at a relatively low temperature.

Japanese Unexamined Patent Application Publication No. 7-242820 also discloses a heat resistant resin composition comprising a polyimide resin having a glass transition temperature of no more than 350°C, an epoxy compound and a compound having an active hydrogen group which can react with the epoxy compound, to obtain a film adhesive excellent in heat resistance and low-temperature processability. Also in this composition, a diamino siloxane compound having a specific structure is disclosed to be used for the preparation of the polyimide resin.

For the same purpose as in the above-described Japanese Unexamined Patent Application Publication No. 7-242820, Japanese Unexamined Patent Application Publication No. 7-242821 discloses that a heat-resistant resin composition comprising a polyimide resin having a glass transition temperature of no more than 350°C and obtained from 4,4'-oxydiphthalic dianhydride as an acid component, a diamino siloxane compound having a specific structure and 1,3-bis(3-aminophenoxy)benzene as amine components, an epoxy compound and a compound having an active hydrogen group which can react with the epoxy compound.

Further, Japanese Unexamined Patent Application Publication No. 2000-143981 discloses a resin composition comprising a polyimide resin obtained from an ester dianhydride having a specific structure, an aromatic diamine having a specific structure and siloxane diamine having a specific structure, and an epoxy resin. This resin composition is described to be excellent in resistance to water absorption, solder heat-resistance, heat-resistance and adhesion, and able to adhere at low temperature. EP0598911 concerns an adhesive mainly comprising a polyimide resin which has a glass transition point of 350°C or below and is soluble in organic solvents. The polyimide resin is obtained by reacting dianhydrides selected from 4,4'-oxydiphthalic dianhydride, 3,3',4,4'-biphenyltetracarboxylic dianhydride and 3,3',4,4'-benzophenonetetracarboxylic dianhydride and amine compounds selected from aromatic diamines and siloxane amines.

JP8127656 relates to a polyimide, which can be used as a heat-resistent adhesive said to exhibit high bond strength at low pressure and low temperature. This polyimide is obtained by reacting a diamine comprising six aromatic rings such as 4,4'-bis[4-(4- aminophenoxy)phenoxy]diphenyl sulfone, a specific siloxane diamine and an aromatic tetracarboxylic acid anhydride.

Polyimides useful as heat-resistant adhesive that enables bonding with high bond strength at a low temperature and low pressure are also described in JP8134213. These polyimides are produced by reacting an aromatic diamine having four aromatic rings such as 4,4'-bis(4-aminophenoxy)diphenyl ether, a specific siloxane compound and a tetracarboxylic acid dianhydride.

However, it is difficult to obtain a resin composition which satisfies all the required properties of an adhesive, and thus research for developing this is in progress at present. Particularly, if a film adhesive or the peripheral members excessively absorb water, the water may be thermal-expanded when a semiconductor device is mounted to a motherboard, etc., at high temperature (reflow process), thereby causing blisters and peeling. Therefore, a film adhesive having low moisture absorption as well as high adhesion strength is required.

Accordingly, an object of the present invention is to provide an adhesive resin comprising a polyimide resin excellent in low-temperature adhesion, heat-resistance, resistance to moisture absorption, a film adhesive comprising the adhesive resin suitable for attaching a semiconductor element to a support, and a semiconductor device made by using the film adhesive.

### Disclosure of Invention

An adhesive resin comprising a polyimide resin according to the present invention is a polyimide resin obtained by reacting a diamine component containing a diamine represented by the following formula (1) as an essential component with a tetracarboxylic dianhydride component, 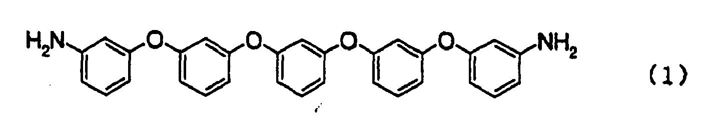 wherein the polyimide resin contains a diamine represented by the following formula (2) as a diamine component, 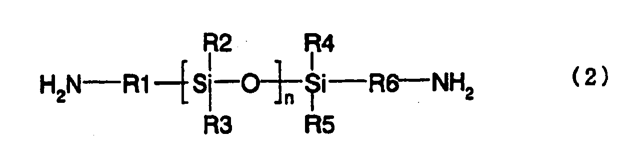 (wherein R1 and R6 are divalent aliphatic groups having 1 to 4 carbon atoms or aromatic groups; R2 to R5 are monovalent aliphatic groups or aromatic groups; and n is an integer of 0 to 20)
and/or a tetracarboxylic dianhydride represented by the following formula (3) as the tetracarboxylic dianhydride component, 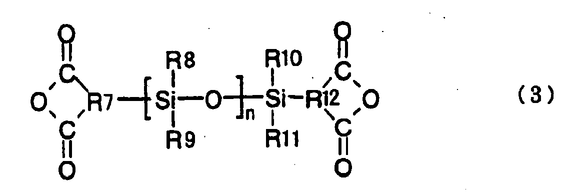 (wherein R7 and R12 are trivalent aliphatic groups or aromatic groups; R8 to R11 are monovalent aliphatic groups or aromatic groups; the carbon skeleton of the acid anhydride structure is a 5- or 6-membered ring; and n is an integer of 0 to 20).

In a preferred embodiment of the present invention, the adhesive resin is a resin composition comprising a thermosetting resin except a polyimide resin. The term "resin" as used herein includes a "resin composition".

In another preferred embodiment of the present invention, the thermosetting resin comprises an epoxy resin, and the adhesive resin is a resin composition comprising an epoxy resin-curing ageht.

In still another preferred embodiment of the present invention, the adhesive resin is a resin composition comprising inorganic filler.

The present invention provides a film adhesive comprising the adhesive resin.

The present invention also provides a semiconductor device wherein a semiconductor element is attached to a support by the film adhesive.

### Best Mode for Carrying Out the Invention

Hereinafter, an adhesive resin comprising a polyimide resin obtained by reacting a diamine component containing a diamine represented by the following formula (1) as an essential component with a tetracarboxylic dianhydride component will be described in detail.

An adhesive resin in the present invention is a polyimide resin obtained by reacting a diamine component containing a diamine represented by the following formula (1) as an essential component with a tetracarboxylic dianhydride component, and the polyimide contains a diamine represented by the following formula (2) as a diamine component, and/or a tetracarboxylic dianhydride represented by the following formula (3) as the tetracarboxylic dianhydride component. 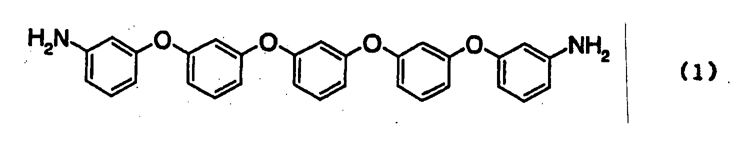 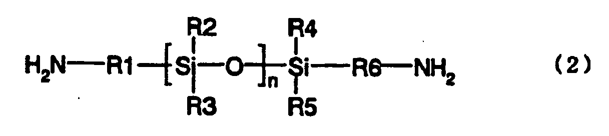 (wherein R1 and R6 are divalent aliphatic groups having 1 to 4 carbon atoms or aromatic groups; R2 to R5 are monovalent aliphatic groups or aromatic groups; and n is an integer of 0 to 20) 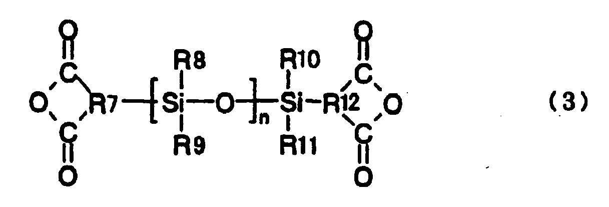 (wherein R7 and R12 are trivalent aliphatic groups or aromatic groups; R8 to R11 are monovalent aliphatic groups or aromatic groups; the carbon skeleton of the acid anhydride structure is a 5- or 6-membered ring; and n is an integer of 0 to 20)

The diamine represented by the formula (1) (hereinafter, referred to as the aromatic diamine) has a reduced density of the imide group due to a long distance between amines as an aromatic diamine, and are excellent in resistance to moisture absorption.

Adhesion temperature of an adhesive resin is related to its glass transition temperature (Tg), and lowering Tg of a resin is generally conducted when the resin should be improved in order to attach at reduced temperature. 1,3-bis(3-(3-aminophenoxy)phenoxy)benzene of the following formula (1) is used since it has flexible molecular structure, and thus a polyimide resin synthesized from it has a low glass transition temperature (Tg), thereby improving low-temperature adhesion.

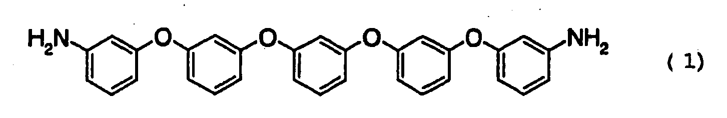

In the diamine (hereinafter, referred to as the silicone diamine) represented by the formula (2), R1 and R6 are a divalent aliphatic groups having 1 to 4 carbon atoms or aromatic groups, and preferably aromatic groups in terms of heat-resistance and reactivity. Specific examples include an aliphatic group having 3 carbon atoms or -Bz-O-(CH₂)₄-(Bz represents a benzene ring). Among them, the aliphatic group having 3 carbon atoms is more preferable in that the corresponding diamine is commercially available and it is easy to obtain. The adhesive using this has also sufficient heat-resistance.

R2 to R5 are monovalent aliphatic groups or aromatic groups, and the examples include a methyl group and a phenyl group. Among these, general methyl groups are preferred since a structure having aromatic groups on only one side may cause environmental problems (environmental hormones) though the phenyl group is preferred in terms of compatibility with an aromatic thermosetting resin.

The silicone diamine represented by the formula (2) is also effective to lower Tg of the polyimide resin, and Tg may be controlled by the chain length or the amount of added silicone diamine. n is preferably an integer of 0 to 20, and more preferably, an integer of 1 to 10 in terms of adhesion since the long-chain structure when n is near 20, is known to have tendency to lower adhesion.

Examples of the silicone diamine include α,ω-bis(3-aminopropyl)polydimethyl siloxane, ω,ω'-bis(2-aminoethyl)polydimethyl siloxane, ω,ω'-bis(3-aminopropyl)polydimethyl siloxane, ω,ω'-bis(4-aminophenyl)polydimethyl siloxane, ω,ω'-bis(4-amino-3-methyl phenyl)polydimethyl siloxane, ω,ω'-bis(3-aminopropyl)polydiphenyl siloxane and the like, but are not limited to these.

As for the content ratio of the aromatic diamine to the silicone diamine among the diamine component, the aromatic diamine is preferably 99 to 10 mole%, and more preferably 80 to 10 mole% among the total amount of the diamine component, and silicone diamine is preferably 1 to 90 mole%, and more preferably 20 to 90 mole% especially in terms of low-temperature adhesion among the total amount of the diamine component.

In tetracarboxylic dianhydride represented by the formula (3) (hereinafter, referred to as the silicone acid dianhydride), R7 and R12 are trivalent aliphatic groups or aromatic groups, and the aromatic group is preferable in terms of heat-resistance. However, if aliphatic groups are used within the range of the manufacturing process temperature of semiconductor devices, it has not a problem particularly.

R8 to R11 are monovalent aliphatic groups or aromatic groups.

The carbon skeleton of the acid anhydride is a 5-membered ring or a 6-membered ring, and the 5-membered ring is preferable. In case of the 5-membered ring, the acid anhydride is preferably bonded to a benzene ring.

The silicone acid dianhydride represented by the formula (3) is also effective in lowering Tg of the polyimide resin, and Tg may be controlled by the chain length or the amount of added silicone acid dianhydride. n is preferably an integer of 0 to 20, and more preferably, an integer of 1 to 10 in terms of adhesion strength.

Examples of the silicone acid dianhydride include compounds of the following formulae (5) and (6), but are not limited to these. 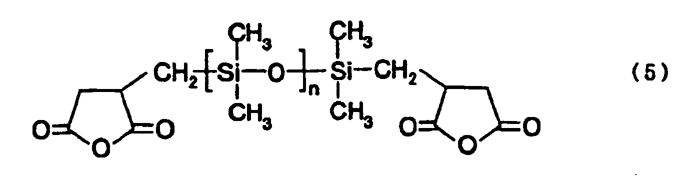 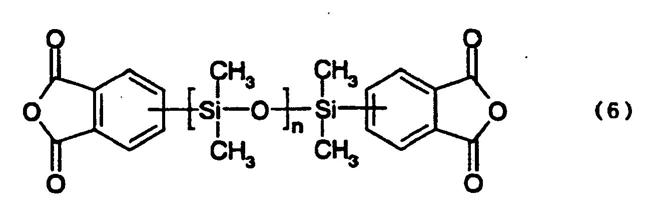 wherein n is preferably an integer of 0 to 20, more preferably an integer of 1 to 10 in terms of adhesion strength.

By introducing the silicone structure into the acid anhydride like the formula (3) other than into the diamine, the aromatic diamine structure of the formula (1) which has a long-chain monomer structure can be introduced more as a diamine component. Therefore, high moisture absorption or hydrolysis which is a characteristic problem of general polyimide resin may be improved by reducing the density of the imide group.

A polyimide resin having silicone structure generally has advantages such as enhanced solvent solubility, lowered moisture absorption, increased adhesion strength to glass, silicon and the like, a low Tg and improved solvent dryness, but has disadvantages such as low adhesion strength to other materials than glass, silicon and the like, and worse compatibility with thermosetting resins such as epoxy resins. Therefore, by introducing the aromatic diamine structure of the formula (1), the properties of aromatic imide may be expressed strongly, and excellent adhesion strength to various types of adherend may be achieved with good balance.

The mixing ratio of the silicone acid dianhydride among the tetracarboxylic dianhydride component may be several mole% when used only for improving adhesion strength to an adherend such as glass and silicon. However, it is preferably several tens of mole% depending on the adhesion temperature when used in order to improve adhesion at a low temperature. Accordingly, the mixing ratio of the silicone acid dianhydride among the tetracarboxylic dianhydride component is preferably 5 to 100 mole% since within that range, the effects of the present invention are prominent. In the present invention, other diamines in addition to the above-described diamine may be added, if desired, within the range that they do not adversely affect the object of the present invention. Examples of the other diamines are not limited particularly to, but include aliphatic diamines such as 1,2-diaminoethane, 1,3-diaminopropane, 1,4-diaminobutane, 1,5-diaminopentane, 1,6-diaminohexane, 1,7-diaminoheptane, 1,8-diaminooctane, 1,9-diaminononane, 1,10-diaminodecane, 1,11-diaminoundecane and 1,12-diaminododecane; and aromatic diamines such as o-phenylene diamine, m-phenylene diamine, p-phenylene diamine, 3,3'-diaminodiphenyl ether, 3,4'-diaminodiphenyl ether, 4,4'-diaminodiphenyl ether, 3,3'-diaminodiphenyl methane, 3,4-diaminodiphenyl methane, 4,4-diaminodiphenyl methane, 3,3'-diaminodiphenyl difluoromethane, 3,4'-diaminodiphenyl difluoromethane, 4,4'-diaminodiphenyl difluoromethane, 3,3'-diaminodiphenyl sulfone, 3,4'-diaminodiphenyl sulfone, 4,4'-diaminodiphenyl sulfone, 3,3'-diaminodiphenyl sulfide, 3,4'-diaminodiphenyl sulfide, 4,4'-diaminodiphenyl sulfide, 3,3'-diaminodiphenyl ketone, 3,4'-diaminodiphenyl ketone, 4,4'-diaminodiphenyl ketone, 2,2-bis(3-aminophenyl)propane, 2,2'-(3,4'-diaminodiphenyl)propane, 2,2-bis(4-aminophenyl)propane, 2,2-bis(3-aminophenyl)hexafluoropropane, 2,2-(3,4'-diaminodiphenyl)hexafluoropropane, 2,2-bis(4-aminophenyl)hexafluoropropane, 1,3-bis(3-aminophenoxy)benzene, 1,4-bis(3-aminophenoxy)benzene, 1,4-bis(4-aminophenoxy)benzene, 3,3'-(1,4-phenylene bis(1-methyl ethylidene))bisaniline, 3,4'-(1,4-phenylene bis(1-methyl ethylidene))bisaniline, 4,4'-(1,4-phenylene bis(1-methyl ethylidene))bisaniline, 2,2-bis(4-(3-aminophenoxy)phenyl)propane, 2,2-bis(4-(4-aminophenoxy)phenyl)propane, 2,2-bis(4-(3-aminophenoxy)phenyl)hexafluoropropane, 2,2-bis(4-(4-aminophenoxy)phenyl)hexafluoropropane, bis(4-(3-aminophenoxy)phenyl)sulfide, bis(4-(4-aminophenoxy)phenyl)sulfide, bis(4-(3-aminophenoxy)phenyl)sulfone, bis(4-(4-aminophenoxy)phenyl)sulfone, 3,3'-dimethoxy-4,4'-diaminobiphenyl, 4,4'-methylene-bis(2,6-diethyl aniline), o-tolidine sulfone, 1,4-bis(4-aminophenoxy)benzene, 4,4-methylene-bis(2,6-diisopropyl aniline), 4,4'-bis(4-aminophenoxy)biphenyl and 1,1-bis(4-(4-aminophenoxy)phenyl)cyclohexane.

The polyimide resin constituting the adhesive resin of the present invention may be obtained by reacting the above-described diamine components with acid dianhydrides. Since Tg of the polyimide resin can also be controlled by the structure of the tetracarboxylic dianhydride which is reacted with the diamine components, the tetracarboxylic dianhydride used in the present invention may be selected for that purpose.

Examples of the tetracarboxylic dianhydride be available in the present invention other than the above-described silicone acid dianhydride, include pyromellitic dianhydride, 3,3',4,4'-diphenyl tetracarboxylic dianhydride, 2,2',3,3'-diphenyl tetracarboxylic dianhydride, 2,2-bis(3,4-dicarboxyphenyl)propane dianhydride, 2,2-bis(2,3-dicarboxyphenyl)propane dianhydride, 1,1-bis(2,3-dicarboxyphenyl)ethane dianhydride, 1,1-bis(3,4-dicarboxyphenyl)ethane dianhydride, bis(2,3-dicarboxyphenyl)methane dianhydride, bis(3,4-dicarboxyphenyl)methane dianhydride, bis(3,4-dicarboxyphenyl)sulfone dianhydride, 3,4,9,10-perylene tetracarboxylic dianhydride, bis(3,4-dicarboxyphenyl)ether dianhydride, benzene-1,2,3,4-tetracarboxylic dianhydride, 3,4,3',4'-benzophenone tetracarboxylic dianhydride, 2,3,2',3-benzophenone tetracarboxylic dianhydride, 2,3,3',4'-benzophenone tetracarboxylic dianhydride, 1,2,5,6-naphthalene tetracarboxylic dianhydride, 2,3,6,7-naphthalene tetracarboxylic dianhydride, 1,2,4,5-naphthalene tetracarboxylic dianhydride, 1,4,5,8-naphthalene tetracarboxylic dianhydride, 2,6-dichloronaphthalene-1,4,5,8-tetracarboxylic dianhydride, 2,7-dichloronaphthalene-1,4,5,8-tetracarboxylic dianhydride, 2,3,6,7-tetrachloronaphthalene-1,4,5,8-tetracarboxylic dianhydride, phenanthrene-1,8,9,10-tetracarboxylic dianhydride, pyrazine-2,3,5,6-tetracarboxylic dianhydride, thiophene-2,3,4,5-tetracarboxylic dianhydride, 2,3,3',4'-biphenyl tetracarboxylic dianhydride, 3,4,3',4'-biphenyl tetracarboxylic dianhydride, 2,3,2',3'-biphenyl tetracarboxylic dianhydride, bis(3,4-dicarboxyphenyl)dimethylsilane dianhydride, bis(3,4-dicarboxyphenyl)methyl phenylsilane dianhydride, bis(3,4-dicarboxyphenyl) diphenylsilane dianhydride, 1,4-bis(3,4-dicarboxyphenyl dimethyl silyl)benzene dianhydride, 1,3-bis(3,4-dicarboxyphenyl)-1,1,3,3-tetramethyl dicyclohexane dianhydride, p-phenyl bis(trimellitic monoesteric anhydride),ethylene tetracarboxylic dianhydride, 1,2,3,4-butane tetracarboxylic dianhydride, decahydronaphthalene-1,4,5,8-tetracarboxylic dianhydride, 4,8-dimethyl-1,2,3,5,6,7-hexahydronaphthalene-1,2,5,6-tetracarboxylic dianhydride, cyclopentane-1,2,3,4-tetracarboxylic dianhydride, pyrrolidin-2,3,4,5-tetracarboxylic dianhydride, 1,2,3,4-cyclobutane tetracarboxylic dianhydride, bis(exo-bicyclo[2,2,1]heptane-2,3-dicarboxylic anhydride)sulfone, bicyclo-(2,2,2)-octo(7)-en-2,3,5,6-tetracarboxylic dianhydride, 2,2-bis(3,4-dicarboxyphenyl)hexafluoropropane dianhydride, 2,2-bis[4-(3,4-dicarboxyphenoxy)phenyl]hexafluoropropane dianhydride, 4,4'-bis(3,4-dicarboxyphenoxy)diphenylsulfide dianhydride, 1,4-bis(2-hydroxyhexafluoroisopropyl)benzene bis(trimellitic anhydride), 1,3-bis(2-hydroxyhexafluoroisopropyl)benzene bis(trimellitic anhydride), 5-(2,5-dioxotetrahydrofuryl)-3-methyl-3-cyclohexene-1,2-dicarboxylic anhydride, tetrahydrofuran-2,3,4,5-tetracarboxylic dianhydride, ethylene glycol bistrimellitic dianhydride and the like. These diamines may be used alone, or in a mixture of two or more thereof.

Among these, one or more kinds of tetracarboxylic dianhydride selected from the group consisting of 4,4'-oxydiphthalic dianhydride, 3,3',4,4'-biphenyl tetracarboxylic dianhydride, 3,3',4,4'-benzophenone tetracarboxylic dianhydride, ethylene glycol bistrimellitic dianhydride, pyromellitic dianhydride, and 3,3',4,4'-diphenyl sulfone tetracarboxylic dianhydride are preferable.

To prepare a heat-resistant cross-linking structure with polyimide resin alone, 3,3',4,4'-benzophenone tetracarboxylic dianhydride is particularly effective, preferably in the amount of 10 to 100 mole% of tetracarboxylic dianhydride component. This is considered to be due to the reaction of carbonyl group with amine to form an imine bond. In order to enable low-temperature adhesion, it is necessary to sufficiently lower Tg below adhesion temperature, and for this purpose, 4,4'-oxydiphthalic dianhydride, ethylene glycol bistrimellitic dianhydride, and the like are preferable.

The condensation reaction of the tetracarboxylic dianhydride component and the diamine component may be carried out in an organic solvent by the known method. The equivalent ratio of the acid component to the amine component in the condensation reaction is an important factor for determining the molecular weight of the polyamic acid obtained. It is well-known that there is a correlation between the molecular weight of a polymer and the physical properties of the polymer, particularly between the number average molecular weight and the mechanical properties. As the number average molecular weight is larger, the mechanical property is better. Accordingly, in order to obtain a good practical strength, it is necessary that the molecular weight be high to some extent.

In the present invention, when the mole number of tetracarboxylic dianhydride is defined as "a" as the acid component, that of the diamine represented by the formula (1) is defined as "b", that of the diamine represented by the formula (2) is defined as "c" as the diamine component, and that of the other diamine is defined as "d" as the amine component, the molar ratio of a, b, c and d is preferably that corresponding to ≤ a/(b + c + d) ≤ 1.1, and more preferably 0.975 ≤ a/(b + c + d) ≤ 1.06 (a/(b + c + d) refers to the equivalent ratio). When the equivalent ratio is less than 0.9, the molecular weight may be low and the polymer may become brittle, and hence, the bonding strength may become weak. Also, when the equivalent ratio exceeds 1.1, the unreacted carboxylic acid may undergo decarboxylation under heating to generate gas, whereby foaming may be caused, so that it may not be preferable.

Examples of the organic solvent that may be used in the reaction include dimethyl acetamide, dimethyl formamide, N-methyl-2-pyrrolidone, dimethyl sulfoxide, hexamethyl phosphoryl amide, m-cresol, o-chlorophenol, tetrahydrofuran and the like. These solvents may be used alone, or in an admixture of two or more thereof. Also, the addition of each component may be in any order.

First, polyamic acid, a precursor of the polyimide resin, is synthesized. The reaction temperature of polyamic acid synthesis is usually no more than 80°C, preferably 0 to 50°C. As the reaction proceeds, the viscosity of the reaction solution increases slowly. Then, the reactant (polyamic acid) is subjected to dehydration-cyclization to give polyimide resin. The dehydration-cyclization may be carried out by heating at 120°C to 250°C, or by other chemical methods.

In case of the heating at 120°C to 250°C, it is preferably carried out with removing the water generated by the dehydration reaction from the system. At this time, the water may be azeotropically distilled off using benzene, toluene, xylene, trimethyl benzene, and the like.

In case that the dehydration-cyclization is carried out by a chemical method, as a cyclizing agent, an acid anhydride such as acetic anhydride, propionic anhydride, and benzoic anhydride, and a carbodiimide compound such as dicyclohexyl carbodiimide and the like may be used. If necessary, a cyclization catalyst such as pyridine, isoquinoline, trimethyl amine, triethylamine, aminopyridine and imidazole may be used. The cyclizing agent and the cyclization catalyst are used preferably in the range of 1 to 8 moles, respectively, with respect to 1 mole of tetracarboxylic dianhydride. The reaction temperature may be lower than that of the heating method for imidization. Following the synthesis of the polyimide resin, the polyimide resin solution is poured into a poor solvent to precipitate the polyimide resin and to separate the catalyst, and the like.

Also, the dehydration-cyclization may be carried out at the time of flexible molding to obtain a film adhesive as described below. In other words, after coating of polyamic acid varnish on a support with a coating apparatus such as flow coater and roll coater, the dehydration-cyclization is carried out by introduction into a hot-air drying oven, and volatilizing the solvent of the varnish.

In the present invention, the "polyimide resin" is intended to include the polyimide resin wherein the precursor thereof, polyamic acid partially remains in addition to 100% imidated polyimide resin.

The adhesive resin of the present invention preferably contains thermosetting resins other than the polyimide resin. The thermosetting resin is not particularly limited if it is at least partially compatible with the polyimide resin. Examples of the thermosetting resins include epoxy resin, bismaleimide resin, diallyl phthalate, acrylic resin, benzooxazine resin, and the like.

The content ratio of the thermosetting resin among the adhesive resin composition is preferably 1 to 200 parts by weight, and more preferably 5 to 100 parts by weight with respect to 100 parts by weight of the polyimide resin in terms of excellent heat-resistance, suitable fluidity at the time of adhesion and improved film moldability.

Among these thermosetting resins, epoxy resin is preferable since various types of products of various structures are commercially available, and suitable thermosetting conditions can be achieved, and the cross-linking density can be controlled with mixing ratio. The epoxy resin is not particularly limited if it has at least 2 epoxy groups in the molecular. For example, as an epoxy resin of glycidyl ether type of phenol, a condensate of bisphenol A, bisphenol AD, bisphenol S, bisphenol F or halogenated bisphenol A with epichlorohydrin, glycidyl ether of phenol novolak resin, glycidyl ether of cresol novolak resin, glycidyl ether of bisphenol A novolak resin, glycidyl ether of dicyclopentadiene modified phenol novolak resin, biphenyl type epoxy resin, and the like are included.

When an epoxy resin is used as the thermosetting resin, the epoxy resin may form a cross-linking structure having a moisture resistance and a heat resistance which cannot be obtained with polyimide resin alone since it has reactivity with a functional group such as acid, amine which exists at the end of polyimide of polyimide resin and incompletely imidated amic acid. At the time of adhesion in the uncured state, the epoxy resin also offers plasticity to the adhesive resin as a low-molecular weight substance, lowers the melt viscosity of the resin, improves wetting to an adherend of the resin, and contributes to low-temperature adhesion.

When an epoxy resin is used as the thermosetting resin, an epoxy resin-curing agent is preferably further used in the adhesive resin composition of the present invention. The epoxy resin-curing agent is not particularly limited if it has reactivity to the epoxy resin to cure epoxy resin. Typical examples of the agents include phenol-type curing agents, amine-type curing agents, acid anhydride-type curing agents, imidazoles, and the like.

The mixing ratio of the epoxy resin-curing agent is preferably less than equal in equivalent to the epoxy resin because if the epoxy resin-curing agent remains as an unreacted material, it may deteriorate the hygroscopic property of the adhesive resin.

The adhesive resin (composition) used in the present invention preferably contain inorganic filler. The inorganic filler may give low thermal expansion, resistance to moisture absorption, high elasticity, high heat conduction, and the like to the adhesive resin. The inorganic filler may also contribute to strength improvement of a film adhesive comprising the adhesive resin or adjustment of melt viscosity. Examples of the filler include an inorganic insulator such as silica, alumina, silicon nitride, aluminum nitride, boron nitride, titanium dioxide, glass, ferrous oxide and ceramic. The filler may be used alone, or in an admixture of two or more thereof.

The mixing ratio of inorganic filler is preferably 0 to 70 volume%. If flexibility as film is considered ,it is more preferably 0 to 30 volume%, and further more preferably 5 to 20 volume% to the total volume including the polyimide resin, the thermosetting resin, the epoxy resin-curing agent if the thermosetting resin is an epoxy resin, and the filler. Within this range, excellent adhesion may be retained. Conductive particles such as metal or anisotropic conductive particles may be also added to impart electric conduction to the adhesive resin of the present invention.

Furthermore, if necessary, additives such as a coupling agent like silane coupling agent and titanium coupling agent may be suitably added to the adhesive resin of the present invention within the range that the object of the present invention may not be damaged. The coupling agent may contribute to improvement of adhesion strength in the adhesion interface of an adherend or inorganic filler.

The adhesive resin of the present invention may be used in the form of varnish by adding preferably thermosetting resin, preferably epoxy resin, and the like to the polyimide resin, and dissolving and stirring in an organic solvent. The organic solvent used herein is not particularly limited if the above-described materials can be homogeneously dissolved or mixed in the solvent, and examples of the solvents include dimethyl formamide, dimethyl acetamide, N-methyl pyrrolidone, dimethyl sulfoxide, diethylene glycol dimethyl ether, toluene, benzene, xylene, mesitylene, methylethyl ketone, tetrahydrofuran, ethyl Cellosolve, ethyl Cellosolve acetate, butyl Cellosolve, dioxane and the like.

If necessary, inorganic filler, additives and the like may then be added to obtain a mixture in a paste state. In this case, mixing may be conducted by suitably using conventional mixer, ston miller, 3-roll mill, ball mill, bead mill, ultrasonic disperser, disperser using collision system against ultrahigh pressure and the like, and so on.

For example a film adhesive may be prepared by coating homogeneously the above-described mixture as varnish or paste onto the base film such as polyolefin film and PET (polyethylene terephthalate) film surface-treated with silicone resin having an excellent peeling property, and then heating under conditions sufficient to volatize the solvent, i.e., generally at the temperature of 60 to 200°C for 1 to 30 minutes to give a monolayer-film adhesive released from the base film.

Also, when attached to a supporting film such as a heat-resistant core film, or metal foil, and the like, a film adhesive may be manufactured by coating the above-described varnish or paste mixture onto one or both of the surfaces, and heating and drying to evaporate the solvent. The method for preparation of the film adhesive is not limited to the above-described methods.

The film adhesive obtained from the present invention may be used to attach a semiconductor device to a support member of IC package. By processing to a film, workability in adhering and size accuracy of adhesion site may become excellent. For example, when the film adhesive of the present invention is used to attach a semiconductor device to a support such as a flexible substrate, the adhesion may be performed by the following methods.

The film adhesive is subjected to attaching to the back surface of the heated semiconductor wafer by roll, and the film adhesive is cut at the outer circumference of the wafer to give a wafer to which the film adhesive is adhered. This is then subjected to dicing, thereby gives a film adhesive-attached device. Then, this is subjected to thermal compression to a support (a lead frame, a rigid substrate, a flexible substrate, a chip in case of a laminated chip, a spacer, and the like). The method of attaching the film adhesive of the present invention is not limited to the above-exemplified method.

Examples of a semiconductor apparatus obtained by attaching a semiconductor element to a support member with the film adhesive comprising the adhesive resin of the present invention include a variety of semiconductor packages, or a semiconductor apparatus made by directly attaching the device to a substrate (including rigid substrate and flexible substrate), and the like.

Hereinafter, the present invention will be explained referring to Examples, however, the present invention should not be construed to be limited thereto.

### (Synthetic Example 1)

Into a 300 ml four-necked flask equipped with a thermometer and a stirrer were placed 10.86 g (22.8 mmol) of 1,3-bis(3-(3-aminophenoxy)phenoxy)benzene (APB5, a compound of the formula (1)), 30.97 g (34.2 mmol) of α,ω-bis (3-aminopropyl)polydimethyl siloxane (APPS, manufactured by Dow Corning Toray Silicone Co., Ltd., amino end silicone BY16-853U, amino value 453 (a compound of the formula (2)), 84 g of N-methyl-2-pyrrolidone (NMP), and 56 g of tetrahydrofuran (THF), and the flask was heated with hot-water and stirred under nitrogen gas flowing to dissolve the diamines. While cooling the flask in an ice bath, 18.17 g (56.4 mmol) of 3,3',4,4'-benzophenone tetracarboxylic dianhydride (BTDA) was added portionwise (tetracarboxylic dianhydride/diamine (molar ratio) = 0.99). The reaction was conducted for 4 hours at the ice-water temperature, to give polyamic acid varnish (P-1).

### (Synthetic Example 2)

Polyamic acid varnish (P-2) was obtained in the same manner as in Synthetic Example 1 except that 6.66 g (22.8 mmol) of 1,3-bis(3-aminophenoxy)benzene(APB) was used in place of APB5 as an aromatic diamine (tetracarboxylic dianhydride/diamine (molar ratio) = 0.99).

### (Example 1)

The polyamic acid varnish (P-1) obtained in Synthetic Example 1 was applied onto Capton (trademark) film (base film) coated with Teflon (trademark) to a 25 µm dry film thickness and was heated and dried at 80°C for 10 minutes, and subsequently at 180°C for 15 minutes, to give a film adhesive. The film adhesive was easily releasable from Capton (trademark) film, to give a monolayer film adhesive. Physical properties of the film adhesive were measured by the method below. The results are shown in Table 1.

### (Comparative Example 1)

A monolayer film adhesive was obtained in the same manner as in Example 1 except using the polyamic acid varnish (P-2) obtained in Synthetic Example 2. Physical properties of the film adhesive were measured by the method below. The results are shown in Table 1.

### i) Shear adhesion (1)

The monolayer film adhesive released from the base film was cut into a 6 mm × 6 mm square, and this was attached to a 5 mm × 5 mm mirror surface of a silicon chip at 110°C with no air inside, and heated at 180°C for 1 minute. This chip was placed on the silicon mirror surface so that the side of the film adhesive was contacted with the silicon, compressed at 200°C for 30 seconds with a load of 98 N, and then heated at 180°C for 3 hours with no load to give a sample piece. The shear adhesion was measured using a push-pull gauge at a room temperature and an elevated temperature after heating at 260°C for 30 seconds.

### ii) Moisture absorption (1)

Twenty-five (25) sheets of the monolayer film adhesive (25 µm thickness) were set within the flame of 50 mm × 50 mm x 0.5 mm, and pressed by a cylinder press with a 6 cm diameter under a condition of 2 to 4 MPa and at 100°C, to prepare a 50 mm × 50 mm × 0.5 mm sample piece. This sample piece was dried at 125°C for 5 hours, and then the dry weight was measured. After humidifying the sample piece in an environment of 85°C and 85%RH (relative humidity) for 1 week, the sample piece was put into distilled water to cool immediately after taking it out from the constant temperature and humidity chamber, water was wiped off, and the humid weight was measured to calculate the moisture absorption.

### iii) Glass Transition Temperature (Tg)

This was measured by using a TMA (Thermomechanical Analysis) device.

### iv) Peeling Strength (1)

The film adhesive in an attached state on the base film was subjected to thermal compression to polyimide film of 50 µm thickness (manufactured by Ube Industries, Co., LTD., Upilex) at 130°C, and the base film was released. This was cut into thin rectangles of 5 mm width, and attached to the silicon mirror surface with the film adhesive interposed changing the attaching conditions. 90° peeling strength was measured according to the conventional procedure. There were 2 sets of attaching conditions as follows: (a) pressing at 230°C under 3 MPa for 2 seconds, and post-heating at 180°C for 1 minute, and (b) pressing at 110°C under 0.5 MPa for 2 seconds, and post-heating at 180°C for 1 minute.

**Table 1**

| | | Example 1 | Comparative Example 1 |
|---|---|---|---|
| Shear adhesion (1) (Room temp.) | (N/chip) | Chip material was crushed | Chip material was crushed |
| Shear adhesion (1) (260°C) | (N/chip) | 24 | 24 |
| Moisture absorption (1) | (wt%) | 0.2 | 0.3 |
| Tg | (°C) | 58 | 59 |
| Peeling strength (1) (condition (a)) | (N/cm) | 11 | 9 |
| Peeling strength (1) (condition (b)) | (N/cm) | 6 | 4 |

From the above Example and Comparative Example, it is shown that the film adhesive comprising the adhesive resin of the present invention is better with regard to low-temperature adhesion (peeling strength) and resistance to moisture absorption, and also maintains heat-resistance (260°C shear adhesion) when compared to the formulation using the known APB.

### (Synthetic Example 3)

Into a 300 ml five-necked flask equipped with a thermometer, a stirrer, a Dean-Stark tube filled with xylene, and a nitrogen-introducing tube, were placed 11.937 g (25.1 mmol) of APB5, 28.884 g (31.9 mmol) of APPS (amino value 453), 98 g of NMP, and 42 g of m-xylene, and the flask was heated and stirred at 50°C under nitrogen gas flowing. After dissolving the diamines, 14.420 g (43.0 mmol) of 4,4'-oxydiphthalic dianhydride (ODPA) and 6.358 g (14.3 mmol) of ethylene glycol bistrimellitic dianhydride (EGTA) were added portionwise (acid anhydride/amine (molar ratio) = 1.005). While introducing nitrogen gas, the reaction system was heated to 170 to 180°C in an oil bath, and placed for 10 hours while removing the water by azeotropic distillation. Finally, water and xylene were drawn from the Dean-Stark tube, and xylene was removed from the varnish to give a polyimide resin varnish (P-3).

### (Synthetic Example 4)

Polyamic acid varnish (P-4) was obtained in the same manner as in Synthetic Example 3 except that 7.323 g (25.1 mmol) of APB was used in place of APB5 as an aromatic diamine (acid dianhydride/amine (molar ratio) = 1.005).

### (Examples 2 to 4 and Comparative Examples 2 to 4)

Varnishes were prepared according to the mixing ratio shown in Table 2 (unit: parts by weight).

The epoxy resin, the curing agent, and the filler used were as follows.
Epoxy resin: manufactured by Dainippon ink and chemicals, Inc., dicyclopentadiene type epoxy resin HP7200H (epoxy equivalent 280 g/eq),
Epoxy resin-curing agent: manufactured by Shikoku Chemicals, Inc., imidazole curing agent 2PHZ-PW,
Filler: manufactured by Tatsumori, melt silica 1-FX (mean particle size, 0.3 µm).

These were added to the polyimide resin varnish, and was dispersed with a disperser device (manufactured by Thinky "Awatori Rentaro") to give a mixed varnish. 25 parts by weight of filler corresponds to 15 volume% to the total volume including the resin component.

**Table 2**

| | | Example 2 | Comparative Example 2 | Example 3 | Comparative Example 3 | Example 4 | Comparative Example 4 |
|---|---|---|---|---|---|---|---|
| Polyimide resin varnish used | | P-3 | P-4 | P-3 | P-4 | P-3 | P-4 |
| Mixing ratio (parts by weight ) | Polyimide resin (solid) | 100 | 100 | 100 | 100 | 100 | 100 |
| | Epoxy Resin | 10 | 10 | 30 | 30 | 20 | 20 |
| | Epoxy resin-curing agent | 0.3 | 0.3 | 0.9 | 0.9 | 0.5 | 0.5 |
| | Filler | - | - | - | - | 25 | 25 |

The mixed varnish was applied onto surface-treated PET (polyethylene terephthalate) film (Teijin Dupont films, Co., Ltd., A31, 50 µm thickness) by 25 µm of thickness, and heated and dried at 90°C for 20 minutes, to give a film adhesive. Physical properties of the film adhesive were measured by the method below. The results are shown in Table 3.

### v) Shear Adhesion (2)

The film adhesive released from the base film was cut into 6 mm × 6 mm square, and this was inserted between a 5 mm × 5 mm silicon chip and a 20 mm × 20 mm silicon chip, compressed at 200°C for 1 second with a load of 10 N, and then heated to cure at 180°C for 3 hours with no load. The shear adhesion of the sample piece was measured using a push-pull gauge at an elevated temperature after heating at 260°C for 30 seconds.

### vi) Moisture Absorption (2)

Twenty-five (25) sheets of the film adhesive (25 µm thickness) were set within the frame of 50 mm × 50 mm × 0.5 mm, and were pressed by a cylinder press with 6 cm diameter under 2 to 4 MPa of oil pressure in order to prepare a sample piece. This sample piece was dried at 125°C for 5 hours, and then the dry weight was measured. After humidifying the sample piece in an environment of 85°C and 85% RH for 1 week, and the humid weight was measured to calculate the moisture absorption.

### vii) Peeling Strength (2)

The film adhesive in an attached state on the base film was subjected to thermal compression to polyimide film of 50 µm thickness (made by Ube Industries, LTD., Upilex) at 130°C, and the base film was released. This was cut into thin rectangles of 5 mm width. The adhesion surface of 5 mm × 20 mm area of the sample piece was attached to 25 mm × 30 mm of a silicon chip under the conditions of 110°C, a load of 25 N for 2 seconds, and post-heated at 150°C for 1 minute with no load. The sample piece was set in a tensile tester, and 90° peeling strength was measured according to the conventional procedure.

**Table 3**

| | Example 2 | Comparative Example 2 | Example 3 | Comparative Example 3 | Example 4 | Comparative Example 4 |
|---|---|---|---|---|---|---|
| Peeling strength (2) (N/cm) | 7 | 5 | 8 | 6 | 3 | 2 |
| Shear adhesion (2) (N/chip) | 20 | 20 | 25 | 25 | 49 | 39 |
| Moisture absorption (2) (wt%) | 0.3 | 0.6 | 0.4 | 0.8 | 0.3 | 0.5 |

From the above, it is shown that Examples 2, 3 and 4 using the polyimide resin varnish (P-3) obtained in Synthetic Example 3, are better with regard to low-temperature adhesion and resistance to moisture absorption and also maintains equal or better heat-resistance (shear adhesion at elevated temperature) when compared to Comparative Examples 2, 3 and 4 using the polyimide resin varnish (P-4) obtained in Synthetic Example 4.

### (Synthetic Examples 5 to 9)

The polyimide resin varnishes (P-5 to P-9) were obtained using a diamine component and a tetracarboxylic dianhydride component in a molar ratio as indicated in Table 4 in the same manner as in Synthetic Example 3 except the reaction conditions that the additive ratio of NMP and m-xylene (weight ratio) was 7:3, the additive ratio of solid in reacting components was 30 weight%, and the total volume of the additive contents was 70% of the flask volume.

**Table 4**

| Polyimide resin varnishes | P-5 | P-6 | P-7 | P-8 | P-9 |
|---|---|---|---|---|---|
| APB5 | 40 | 44 | 44 | 44 | 44 |
| APPS | 60 | 56 | 56 | 56 | 56 |
| BPDA | 55.55 | | | | |
| ODPA | 45.45 | | | | 101 |
| BADA | | | | 101 | |
| EGTA | | | 101 | | |
| BTDA | | 101 | | | |

In Table 4, BPDA represents 3,4,3',4'-biphenyl tetracarboxylic dianhydride, BADA represents acid dianhydride of the following structural formula, 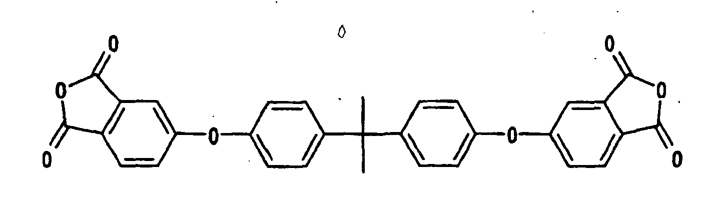 and EGTA represents acid dianhydride of the following structural formula.

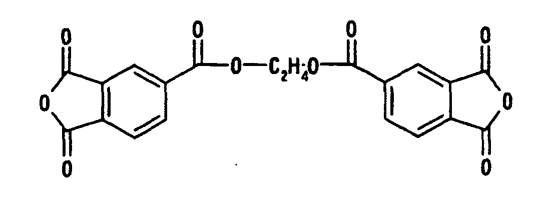

### (Example 5)

To the polyimide resin varnishes P-5 to P-9 were added 20 parts by weight of epoxy resin (manufactured by Mitsui Chemicals, Inc., Techmore (trademark) VG3101L), 1 part by weight of epoxy-curing agent (manufactured by Shikoku Chemicals, Inc., Curezol (trademark), 2MAOK-PW) and 25 parts by weight of filler (manufactured by Tatsumori, melt silica 1-FX (mean particle size 0.3 µm)) (15 volume% to the total volume including the resin component) regarding 100 parts by weight of the solid of the varnishes, and the mixed varnishes were stirred, dispersed, and then coated onto a PET film of 50 µm thickness which had been surface-treated for good release so that the thickness of the dry film was 25 µm. Films were dried at 110°C using a hot-air dryer for 5 minutes to remove the solvent, to give film adhesives (F-5 to F-9 corresponding to varnishes P-5 to P-9, respectively).

F-5 to F-9 released from the base films were cut into 6 mm x 6 mm square, inserted between the polyimide surface of a 5 mm x 5 mm silicon chip to which buffer coat polyimide film of 5 µm thickness was attached, and the mirror surface of 20 mm x 20 mm silicon chip, and compressed under a condition corresponding to the die mount condition, i.e., at 150°C for 1 second and a load of 2.5 N. Then, the sample pieces were subjected to curing at 150°C for 10 minutes, and compression under a condition corresponding to the sealant injection condition, i.e., at 180°C with a load of 98 N for 1 minute, and heated at 180°C for 3 hours with no load as a treatment corresponding to the sealant curing process.

Using these sample pieces as trial pieces for adhesion test between chips of stack package, shear strength was measured with Die Shear Tester (manufactured by Seishin Shoji, Co., Ltd., SS-30W) at 260°C (corresponding to maximum temperature of lead-free solder reflow furnace). The results are shown in Table 5.

**Table 5**

| Film adhesive | F-5 | F-6 | F-7 | F-8 | F-9 |
|---|---|---|---|---|---|
| Shear strength (MPa) | 3 | 3 | 3 | 2 | 4 |

From the above, it was shown that these film adhesives have good compatibility with the polyimide resin and the epoxy resin, and had good adhesion strength (shear strength) without depending on acid anhydride structure.

### (Example 6)

To the polyimide resin varnish P-3 were added 20 parts by weight of an epoxy resin (manufactured by Mitsui Chemicals, Inc., Techmore (trademark) VG3101L), 0.5 parts by weight of an epoxy-curing agent (manufactured by Shikoku Chemicals, Inc., Curezol (trademark), 2MAOK-PW) and 25 parts by weight of filler (manufactured by Tatsumori, melt silica 1-FX) (15 volume% to the total volume including the resin component) regarding 100 parts by weight of the solid varnish. After passing through a stirrer, a disperser, a deaerator, and a filter, the varnish was coated using a precise coater to 270-mm width and 25-µm thickness of dry film onto PET films of 50-µm thickness which had been surface-treated for good release, and continued to dry at 110°C for 5 minutes. This was slit by a width of 240 mm to give a roll of adhesive film that may form film adhesives.

These adhesion films were subjected to adhesion test in a machine for attaching a wafer surface-protecting tape (Takatori, Co., Ltd., DM800A). From the results, the films could be attached at 90°C or more. The attachment between the film and the wafer could be improved by heating at 150°C for 1 minute with no load as post-heating.

Further, these adhesive-attached wafers of 150-µm thickness were mounted on UV-type dicing tape, and subjected to dicing with a dicer per adhesive. The dicing could be performed well. Dicing condition was as follows: 80 mm/s, 30,000 rpm, 20-µm cutting depth, and dicing tape of D-650 manufactured by Lintech company was used.

Chips of 8.5 mm x 8.5 mm were cut by dicing, and were mounted on a dried resin substrate (the substrate: manufactured by BT Resin company, adhesion surface: treated with solder-resist PSR 4000AUS5, manufactured by Taiyo Ink Mfg. Co., Ltd.) at 95°C for 10 seconds under 0.18 MPa of pressure, post-heated at 150°C, and cured for 30 minutes with no load.

The surface of the substrate was then subjected to cleaning in argon plasma under reduced pressure, and the chip and substrate were subjected to bonding at 150°C by ultrasonic wire bonding.

Subsequently, the substrate was sealed in bulk with a sealing resin (manufactured by Hitachi Chemical Co., Ltd., CEL9000) at 175°C for 3 minutes under 10 MPa of pressure, and post-heated at 175°C for 6 hours to completely cure the sealing resin. Further, a lead-free solder ball was mounted in the reflow process at 260°C maximum temperature, and the substrate molded in bulk was individualized by dicing, to give semiconductor devices.

These semiconductor devices were tested according to the procedure for the moisture absorption reflow test of IPC. From the results, neither stripping nor cracking was generated in the semiconductor devices in the reflow process of moisture absorption level 2 (85°C/85%RH, 168 hours) and 260°C maximum temperature.

Furthermore, 12.8 mm × 8.5 mm chips were mounted on the substrate, and subsequently 8.5 mm × 8.5 mm chips were mounted on the chip, and subjected to curing and heating, plasma cleaning, wire bonding, and sealing of resin as described above, in order to prepare a semiconductor device in which chips are laminated in 2 layers.

These semiconductor devices were also investigated for the level of the moisture absorption reflow test of IPC. From the results, neither stripping nor cracking was generated in the semiconductor devices in the reflow process of moisture absorption level 2 (85°C/85%RH, 168 hours) and at a 260°C maximum temperature.

As described above, it was shown that the film adhesive comprising the adhesive resin of the present invention could be used in a semiconductor mounting process under mild conditions of temperatures lower than 100°C, and at high levels in the moisture absorption reflow test, and problems such as warping, which may occur by heating thin wafers or substrates, and the like were also solved.

### (Synthetic Example 10)

Into a 300 ml five-necked flask equipped with a thermometer, a stirrer, a Dean-Stark tube filled with xylene, and a nitrogen-introducing tube, were placed APB5 and silicone acid dianhydride represented by the following formula (7) in the ratio of acid anhydride/amine (molar ratio) = 1.005, and solvents of NMP and m-xylene in the ratio of 7:3, to make 30 weight% of solid and 200 g of total weight. Under nitrogen gas flowing, the reaction system was heated in an oil bath to 170 to 180°C, and retained for 10 hours while removing the water by azeotropic distillation, to give a polyimide resin varnish (P-10).

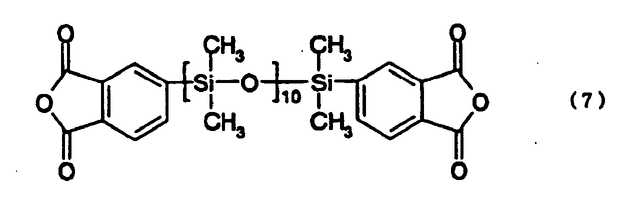

### (Example 7)

To the polyimide resin varnish (P-10) obtained in Synthetic Example 10 were added 20 parts by weight of epoxy resin and 1 part by weight of epoxy-curing agent, which were the same as those used in Example 2 regarding 100 parts by weight of the solid varnish, to give a mixed varnish. This varnish was treated in the same manner as in Example 2 to give film adhesives. Physical properties of these film adhesives were measured by the above and the following methods. The results are shown in Table 6. The sample piece of the shear adhesion (2) was also humidified in an environment of 85°C and 60%RH (relative humidity) for 1 week, and the shear adhesion was measured in the same manner within 30 minutes after taking it out from the humidity chamber. The results are shown together in Table 6.

### viii) Peeling Strength (3)

The film adhesive in an attached state on the base film was subjected to thermal compression to 50-µm thickness of polyimide film (made by Ube Industries, LTD., Upilex) at 110°C, the base film was released, and this was cut into thin rectangles of 5-mm width. The adhesion surface of a 5 mm x 20 mm area of the sample piece was attached to a 25 mm x 30 mm silicon chip under the conditions of 110°C, a load of 25 N, for 2 seconds, and was post-heated at 150° for 1 minute with no load. The sample piece was set in a tensile tester, and 90° peeling strength was measured according to the conventional procedure.

**Table 6**

| | Example 7 |
|---|---|
| Peeling strength (3) (N/cm) | 12 |
| Shear adhesion (2) (N/chip) | 32 |
| Shear adhesion (2) (after moisture absorption) (N/chip) | 27 |
| Moisture absorption (2) (wt%) | 0.3 |

From the above, it is shown that these film adhesives are excellent in resistance to moisture absorption, and shear adhesion after moisture absorption at elevated temperature. From the results, it is shown that the film adhesive made by using the adhesive resin of the present invention is excellent in resistant-reflow reliability of a semiconductor package by preventing damage to the semiconductor package in the reflow process after moisture absorption in the semiconductor package.

### Industrial Applicability

As described above, the adhesive resin comprising the polyimide resin according to the present invention can provide a film adhesive having low-temperature adhesion, resistance to moisture absorption, heat-resistance and workability in adhesive bonding. If this film adhesive is used, a semiconductor element can be attached to the package at low temperature, and further high reflow reliability can be obtained. Therefore, the film adhesive according to the present invention has extremely high industrial value as a microelectronic material and a semiconductor mounting material.

## Claims

1. An adhesive resin comprising a polyimide resin obtained by reacting a diamine component containing a diamine represented by the following formula (1) 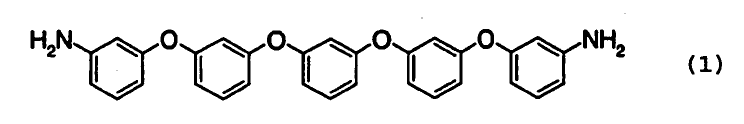 as an essential component with a tetracarboxylic dianhydride component,
wherein the diamine component further comprises a diamine represented by the following formula (2) 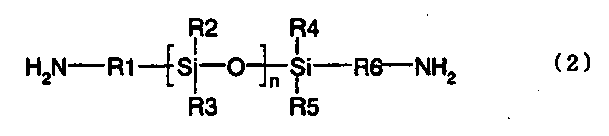 (wherein R1 and R6 are divalent aliphatic groups having 1 to 4 carbon atoms or aromatic groups; R2 to R5 are monovalent aliphatic groups or aromatic groups; and n is an integer of 0 to 20)
and/or
the tetracarboxylic dianhydride component comprises a tetracarboxylic dianhydride represented by the following formula (3) 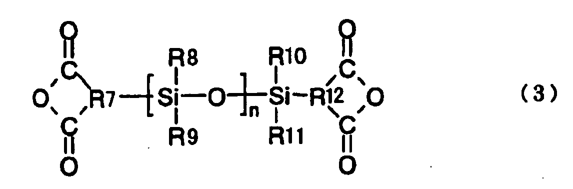 (wherein R7 and R12 are trivalent aliphatic groups or aromatic groups; R8 to R11 are monovalent aliphatic groups or aromatic groups; the carbon skeleton of the acid anhydride structure is a 5- or 6-membered ring; and n is an integer of 0 to 20).

2. The adhesive resin according to Claim 1 comprising a thermosetting resin except a polyimide resin.

3. The adhesive resin according to Claim 2, wherein the thermosetting resin comprises an epoxy resin, and the adhesive resin further comprises an epoxy resin-curing agent.

4. The adhesive resin according to any one of Claims 1 to 3 comprising an inorganic filler.

5. A film adhesive comprising the adhesive resin according to any one of Claims 1 to 4.

6. A semiconductor device wherein a semiconductor element is attached to a support by the film adhesive according to Claim 5

## Patentansprüche

1. Adhäsives Harz, das ein Polyimidharz umfasst, das durch Umsetzen einer Diaminkomponente, die als wesentliche Komponente ein durch die folgende Formel (1) dargestelltes Diamin enthält 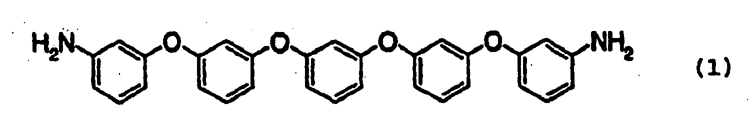 mit einer Tetracarboxyl-Dianhydridkomponente erhalten wird,
worin die Diaminkomponente weiterhin ein durch die folgende Formel (2) dargestelltes Diamin umfasst 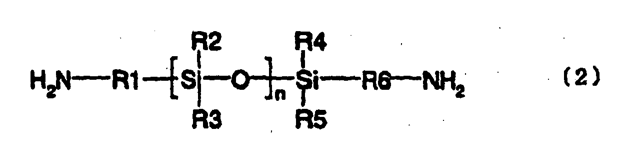 (worin R₁ und R₆ zweiwertige aliphatische Gruppen mit einem bis 4 Kohlenstoffatomen oder aromatische Gruppen sind; R₂ bis R₅ einwertige aliphatische Gruppen oder aromatische Gruppen sind; und n eine ganze Zahl von 0 bis 20 ist)
und/oder
die Tetracarboxyl-Dianhydridkomponente ein durch die folgende Formel (3) dargestelltes Tetracarboxyldianhydrid umfasst, 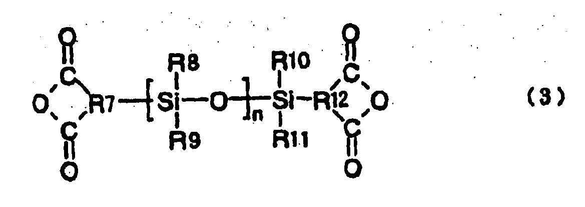 (worin R7 und R12 dreiwertige aliphatische Gruppen oder aromatische Gruppen sind; R8 bis R11 einwertige aliphatische Gruppen oder aromatische Gruppen sind; das Kohlenstoffgerüst der Säureanhydridstruktur ein 5- oder 6-gliedriger Ring ist; und n eine ganze Zahl von 0 bis 20 ist).

2. Adhäsives Harz gemäß Anspruch 1, das ein wärmehärtendes Harz außer einem Polyimidharz umfasst.

3. Adhäsives Harz gemäß Anspruch 2, worin das wärmehärtende Harz ein Epoxyharz umfasst, und das adhäsive Harz weiterhin ein Epoxyharz-Härtungsmittel umfasst.

4. Adhäsives Harz gemäß mindestens einem der Ansprüche 1 bis 3, das einen anorganischen Füllstoff umfasst.

5. Adhäsivfilm, der das adhäsive Harz gemäß mindestens einem der Ansprüche 1 bis 4 umfasst.

6. Halbleitervorrichtung, worin ein Halbleiterelement mit dem Adhäsivfilm gemäß Anspruch 5 an einem Trägerelement befestigt ist.

## Revendications

1. Résine adhésive comprenant une résine polyimide obtenue en faisant réagir un composant diamine contenant une diamine représentée par la formule (1) suivante : 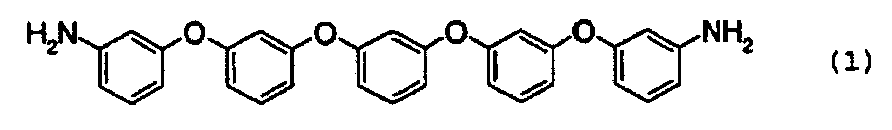 en tant que composant essentiel avec un composant dianhydride tétracarboxylique,
dans laquelle le composant diamine comprend en outre une diamine représentée par la formule (2) suivante : 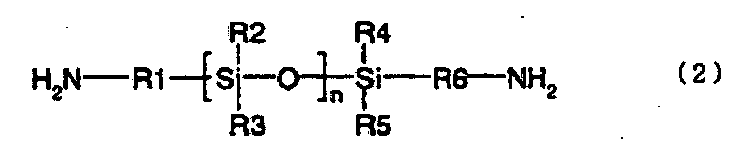 (dans laquelle R1 et R6 sont des groupes aliphatiques divalents ayant 1 à 4 atomes de carbone ou des groupes aromatiques ; R2 à R5 sont des groupes aliphatiques monovalents ou des groupes aromatiques ; et n représente un nombre entier de 0 à 20)
et/ou
le composant dianhydride tétracarboxylique comprend un dianhydride tétracarboxylique représenté par la formule (3) suivante : 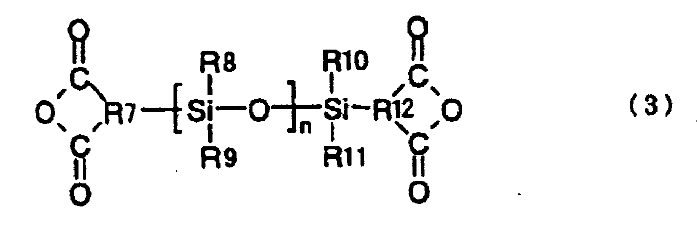 (dans laquelle R7 et R12 sont des groupes aliphatiques trivalents ou des groupes aromatiques ; R8 à R11 sont des groupes aliphatiques monovalents ou des groupes aromatiques ; le squelette carboné de la structure anhydride d'acide est un cycle de 5 ou 6 membres ; et n représente un nombre entier de 0 à 20).

2. Résine adhésive selon la revendication 1 comprenant une résine thermodurcissable à l'exception d'une résine polyimide.

3. Résine adhésive selon la revendication 2, dans laquelle la résine thermodurcissable comprend une résine époxy, et la résine adhésive comprend en outre un agent durcisseur de résine époxy.

4. Résine adhésive selon l'une quelconque des revendications 1 à 3 comprenant une charge inorganique.

5. Adhésif en film comprenant la résine adhésive selon l'une quelconque des revendications 1 à 4.

6. Dispositif à semi-conducteur dans lequel un élément semi-conducteur est attaché à un support par l'adhésif en film selon la revendication 5.
